# EUROPEAN PATENT APPLICATION

(11) **EP 4 625 755 A1**
(43) Date of publication of application: **01.10.2025**
(21) Application number: 24305480.6
(22) Date of filing: 28.03.2024
(51) Int. Cl.: H02J 7/00

(54) **CONTROL DEVICE FOR A BATTERY, SYSTEM AND METHOD FOR THE CONTROL DEVICE**

(71) Applicant: NXP USA, Inc., Austin TX 78735 (US)
(72) Inventor: van Lammeren, Johannes Petrus Maria, 31023 Toulouse (FR); Perruchoud, Philippe Jean-Pierre, 31023 Toulouse (FR)
(74) Representative: Schmütz, Christian Klaus Johannes

(57) **Abstract**

The present invention relates to a control device for a battery for generating a current for an electrochemical impedance spectroscopy. The device is configured to activate two different circuits of the battery via a common energy buffer, so that electrical energy is alternately exchanged between at least two parts of the battery via the energy buffer. Further, the invention relates to a system comprising the control device and the battery. Furthermore, the invention relates to a method for the control device.

## Description

### TECHNICAL FIELD

The present disclosure relates to a control device for a battery, a system comprising the control device and the battery, and a method for the control device.

### BACKGROUND

The trend towards improving batteries for storing electrical energy has grown over several years and supported the use of batteries in many different systems. Nowadays, batteries are often used in vehicles, especially electrically powered vehicles. Batteries may comprise an electrochemical basis for storing electrical energy. In particular, a battery may be a rechargeable battery.

An electric battery may comprise a large number of cells. Several cells may be connected in parallel to form a group. In addition, several groups (each comprising a plurality of cells connected in parallel) may be connected in series.

Electrochemical impedance spectroscopy, which may also be referred to as impedance spectroscopy or impedance measurement, may be used to determine the impedance of a battery. The determination of the impedance of the battery may refer to the determination of the impedance of one or more cells of the battery or to the determination of the impedance of the entire battery (i.e. all cells of the battery). Impedance spectroscopy may provide valuable information about the battery and/or the cells of the battery. For example, impedance spectroscopy or the impedance of the battery may be used to determine a state of charge of the battery and/or a state of health/aging of the battery. Corresponding determinations may also be performed for one or more cells of the battery.

For impedance spectroscopy, an alternating current is often caused to flow through the battery. The alternating current may also be referred to as the measuring current or impedance spectroscopy measuring current. The alternating current may flow completely or proportionately through the cells of the battery. The frequency of the alternating current can be between 100 mHz and 5000 Hz, for example. A low impedance of the battery may indicate a high electrical energy capacity of the battery. If the impedance of the battery decreases over the lifetime of the battery, an increase in the impedance of the battery may indicate a reduced electrical energy capacity of the battery.

Given that a battery often comprises a large number of cells (battery cells), it is of interest to detect the impedance of the battery at the cell level or group level. Due to the large number of cells, the technical measures for impedance spectroscopy of each cell of the multitude of cells may cause a large amount of space and/or increase the complexity of a battery system. The corresponding need for space and/or the complexity to perform the impedance spectroscopy may also lead to high costs to provide the battery and/or a battery system.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

According to a first aspect of the present disclosure, a control device for a battery is provided, wherein the battery comprises a first battery pack, a second battery pack, a first switch unit, a second switch unit and an energy buffer, wherein the energy buffer comprises an inductive and/or capacitive component for buffering electrical energy, wherein the first battery pack, the first switch unit and the energy buffer are integrated into a first circuit of the battery, wherein the second battery pack, the second switching unit and the energy buffer are integrated into a second circuit of the battery, wherein the control device comprises a first control terminal, a second control terminal, a first sensor terminal, and a second sensor terminal, wherein the sensor terminals are configured to be coupled to the energy buffer, wherein the control device is configured to measure a sensor signal at the sensor terminals representing a current flow through the energy buffer, wherein the first control terminal is configured to be coupled to the first switching unit and the second control terminal is configured to be coupled to the second switching unit, wherein the control device is configured to generate an alternating control signal, wherein the control device is configured to receive or generate a periodic reference signal representing successive reference periods each divided into a first reference half period and a second reference half period, wherein the control device is configured to direct the control signal to the first control terminal in each first reference half period such that the first switching unit is driven repeatedly to the closed state via the control signal during each first reference half period, and wherein the control device is configured to direct the control signal to the second control terminal during each second reference half period such that the second switch unit is driven repeatedly to the closed state via the control signal during each second reference half period, and wherein the control unit is configured to adjust the control signal based on the detected sensor signal.

In one or more embodiments, a frequency of the control signal is at least twice as large as a frequency of the reference signal.

In one or more embodiments, the control signal is a pulse width modulated, PWM, signal.

In one or more embodiments, the control signal is structured in a plurality of successive control periods, wherein each control period is divided into a drive time, a release time and a wait time, wherein the control device is configured to generate the control signal such that the control signal is configured to drive the first and/or second switch unit to the closed state during each drive time, and wherein the control device is configured to generate the control signal such that the control signal is configured to drive the first and/or second switch unit to an open state during each release time and/or during each wait time.

In one or more embodiments, the control signal is structured in a plurality of successive control periods, wherein each control period is divided into a drive time, a release time and a wait time, and wherein the control device is configured to generate the control signal such that the control signal is configured as a positive control pulse during each drive period, a zero pulse during each release period, and a zero pulse during each wait period.

In one or more embodiments, for each control period the release time of the respective control period is greater than or equal to the drive time of the same control period.

In one or more embodiments, the control device is configured to measure the sensor signal during a measurement period and to integrate a value of the sensor signal during the measurement period into a first measurement value, wherein the control device is configured to adjust the drive time during the measurement time according to the first measurement value, so that the first measurement value reaches the value zero at the end of the measurement time or a value in a predefined first value range at the end of the measurement time.

In one or more embodiments, the control device is configured, during the measurement period, to adjust the drive time at the end of each control period according to the first measurement value such that the first measurement value reaches zero at the end of the next control period or a value in the predefined first value range at the end of the next control period.

In one or more embodiments, the control device is configured, during the measurement time, to adjust the drive time at the end of each reference half period according to the first measurement value, so that the first measurement value reaches the value zero at the end of the next reference half period or a value in the predefined first value range at the end of the next reference half period.

In one or more embodiments, the first value range is between minus 0.2 and plus 0.2.

In one or more embodiments, the control device is configured to measure the sensor signal during each drive time of each first reference half period of the measurement time and to integrate the respective measured values of the sensor signal into a second measurement value, wherein the control device is configured, during the measurement time, to adjust a frequency of the control signal according to the second measurement value such that the second measurement value reaches a value in a predefined second value range.

In one or more embodiments, the control device is configured to measure the sensor signal during each drive time of the measurement time, wherein the control device is configured to integrate the value of the sensor signal measured exclusively during the drive times of the first reference half periods of the measurement time into a second measurement value, wherein the control device is configured to integrate the value of the sensor signal measured exclusively during the drive times of the second reference half periods of the measurement time into a third measurement value, wherein the control device is configured to form a fourth measurement value from the sum of the magnitude of the second measurement value and the magnitude of the third measurement value, wherein the control device is configured, during the measurement time, to adjust the frequency of the control signal according to the fourth measurement value, so that the fourth measurement value reaches a value within a fourth value range.

According to a second aspect of the present disclosure, a system is provided, wherein the system comprising: a battery, and a control device according to the first aspect and/or any of the preceding embodiments, wherein the battery comprises a first battery pack, a second battery pack, a first switch unit, a second switch unit and an energy buffer, wherein the energy buffer comprises an inductive and/or capacitive component for buffering electrical energy, wherein the first battery pack, the first switch unit and the energy buffer are integrated into a first circuit of the battery, wherein the second battery pack, the second switching unit and the energy buffer are integrated into a second circuit of the battery, wherein the sensor terminals are coupled to the energy buffer so that a sensor signal between the sensor terminals represents a current flow through the energy buffer, and wherein the first control terminal is coupled to the first switching unit, and wherein the second control terminal is coupled to the second switching unit.

In one or more embodiments, the system comprises a first sensor device and an evaluation unit coupled to the first sensor device, wherein the first sensor device is coupled to the first battery pack and configured to measure a voltage of the first battery pack, referred to as the first battery voltage, and wherein the evaluation unit is configured to determine a first impedance of the first battery pack and/or a first state of the first battery pack based on the first battery voltage.

According to a third aspect of the present disclosure, a method for a control device for controlling a battery is provided, wherein the battery comprises a first battery pack, a second battery pack, a first switching unit, a second switching unit and an energy buffer, wherein the energy buffer comprises an inductive and/or capacitive component for buffering electrical energy, wherein the first battery pack, the first switching unit and the energy buffer are integrated into a first circuit of the battery, wherein the second battery pack, the second switching unit and the energy buffer are integrated into a second circuit of the battery, wherein the method comprises the following steps: (a) generate an alternating control signal at the control device, (b) receiving or generating a periodic reference signal at the control device, where the reference signal representing successive reference periods each divided into a first reference half period and a second reference half period, (c) directing the control signal to the first control terminal in each first reference half period such that the first switching unit is driven repeatedly to the closed state via the control signal during each first reference half period, and (d) directing the control signal to the second control terminal during each second reference half period such that the second switch unit is driven repeatedly to the closed state via the control signal during each second reference half period, and (e) adjusting the control signal based on the detected sensor signal.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figures 1 to 3 show each an example a block schematic diagram of the control device and system.
Figures 4a-4e and 5a-5e show a simplified waveform examples of different signals.
Figure 6 shows a simplified flow chart of an example of the method.

### DESCRIPTION OF EMBODIMENTS

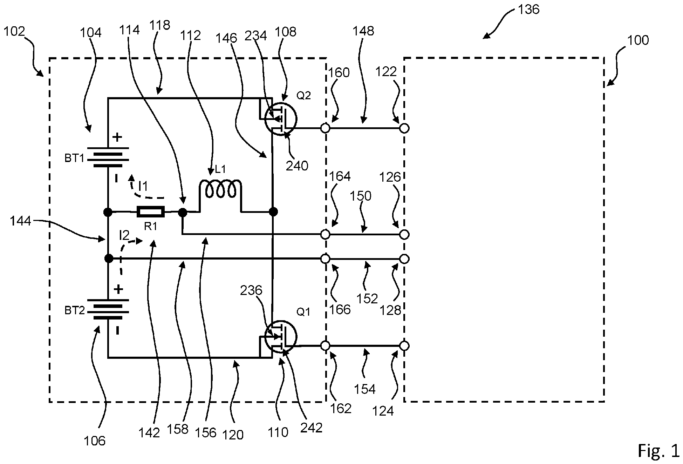

Figure 1 schematically illustrates an example of a battery 102. The battery 102 comprises a first battery pack 104 and a second battery pack 106. Each battery pack 104, 106 may comprise at least one battery cell. In an example, each battery pack 104, 106 comprises a plurality of battery cells. Each battery pack 104, 106 may comprise at least one group of battery cells connected in parallel. The group of multiple battery cells may also be referred to as a cell group. If a battery pack 104, 106 comprises a plurality of cell groups, then the cell groups of the battery pack 104, 106 may be connected in series.

Figure 1 schematically illustrates an example of the battery 102, wherein the battery 102 comprises the first battery pack 104 and the second battery pack 106. The battery 102 may further comprise additional battery packs (not shown). For further explanation, reference is made to the first battery pack 104 and the second battery pack 106. However, the associated explanations may apply analogously to the other battery packs (if any) of the battery 102.

In particular, the first battery pack 104 and the second battery pack 106 may be connected in series via the connection line 144. The first battery pack 104 and the second battery pack 106 may be configured identically. In an example, the first and second battery packs 104, 106 comprise the same number of battery cells. The battery cells may be identically configured. Against this background, a plurality of identical battery cells may be used to build the first battery pack 104 and the second battery pack 106.

The battery 102 may further comprise a first switch unit 108, a second switch unit 110, and an energy buffer 112. In an example, the battery 102 may further comprise other components, such as the resistor 142.

The battery 102 may be configured such that the battery 102 comprises a first circuit 118 and a second circuit 120. The first circuit 118 may include the first battery pack 104, the energy buffer 112, and the first switch unit 108. In the first circuit 118, the first battery pack 104, the energy buffer 112 and the first switch unit 108 may be coupled in series. The first circuit 118 can be closed in a circle. Further components, such as the resistor 142, may be included in the first circuit 118. The second circuit 120 may include the second battery pack 104, the energy buffer 112, and the second switch unit 110. In the second circuit 120, the second battery pack 106, the energy buffer 112, and the second switch unit 110 may be coupled in series. Further components, such as the resistor 142, may be included in the second circuit 120. The energy buffer 112 may comprise an inductive and/or capacitive component for buffering electrical energy. In an example, the energy buffer 112 may be formed by an inductive component, such as an inductor.

Previously, it was explained that impedance spectroscopy may be performed at the level of the battery 102 or at a lower level of the battery 102. In an example, impedance spectroscopy may be performed at the level of the battery packs 104, 106. As a result, the impedance spectroscopy may be performed for the first battery pack 104 and the second battery pack 106.

To perform the impedance spectroscopy for the first battery pack 104, a first current I1 through the first battery pack 104 may be required. The first current I1 through the first battery pack 104 may be caused by closing the first switch unit 108. As an effect, the first current I1 flows through the first circuit 118. As another effect, the first current I1 flows through the energy buffer 112.

In order to perform the impedance spectroscopy for the second battery pack 106, a second current I2 through the second battery pack 106 may be required. The second current I2 through the second battery pack 106 may be caused by closing the second switch unit 110. As an effect, the second current I2 flows through the second switch circuit 120. As another effect, the second current I2 flows through the energy buffer 112.

The first current I1 and the second current I2 can flow through the energy buffer 112 in different directions at different times.

Figure 1 schematically illustrates an example of a control device 100. The control device 100 may be used to control the battery 102. The control device 100 may be used to cause the first current I1 and/or the second current I2 to perform impedance spectroscopy for the first battery pack 104 and/or the second battery pack 106.

The control device 100 comprises a first control terminal 122, a second control terminal 124, a first sensor terminal 126, and a second sensor terminal 128.

The sensor terminals 126, 128 of the control device 100 may be configured to be directly or indirectly coupled to the energy buffer 112 of the battery 102. Coupling to the energy buffer 112 may be achieved, for example, if the sensor terminals 126, 128 are coupled to the first circuit 118 and/or the second circuit 120. In an example, the battery 102 may comprise a string 114 that is a component of both the first circuit 118 and the second circuit 120. The energy buffer 112 may be integrated into the string 114. The sensor terminals 126, 128 of the control device 100 may be configured to be coupled to the string 114 to provide at least indirect coupling to the energy buffer 112 through such coupling. The string 114 may further comprise the resistor 142. The sensor terminals 126, 128 of the control device 100 may be configured to be coupled to nodes upstream and downstream of the resistor 142 of the string 114.

In an example, the control device 100 may be configured to measure a sensor signal at the sensor terminals 126, 128 representing a current through the energy buffer 112. In an example shown in Figure 1, the sensor terminals 126, 128 may be coupled to the string 114 such that the control device 100 may measure, as the sensor signal, a voltage dropped across the resistor 142. The voltage across the resistor 142 may be proportional to the current through the string 114. The voltage measured as the sensor signal may therefore represent the current through the energy buffer 112.

In an example, the first sensor terminal 126 may be coupled to a first battery output 164 via a connection line 150. The first battery output 164 may be coupled to a node of the string 114, which is positioned between the resistor 142 and the energy buffer 112, via a connection line 156. The connection line 150 and the connection line 156 may be configured as a common connection line, in particular omitting the first battery output 164. The second sensor terminal 128 may be coupled to a second battery output 166 via a connection line 152. The second battery output 166 may be directly or indirectly coupled via a connection line 158 to a node of the string 114 arranged between the resistor 142 and the at least one battery pack 104, 106. The connection line 152 and the connection line 158 may be configured as a common connection line, in particular omitting the second battery output 166.

The first control terminal 122 of the control device 100 may be configured to be coupled to the first switch unit 108. In an example, the first control terminal 122 is directly or indirectly coupled to a control terminal of the first switch unit 108. The first switch unit 108 may comprise a first transistor 240, in particular a field effect transistor, such as a MOS transistor. A gate terminal of the first transistor 240 may be configured to control the first transistor 240 and/or the first switch unit 108. In an example, the first switch unit 108 is formed by the first transistor 240. The first control terminal 122 of the control device 100 may be directly or indirectly coupled to the gate terminal of the first transistor 240 of the first switch unit 108, such that the control device 100 may control the first switch unit 108 and/or the first transistor 240 via the first control terminal 122. In an example, the control device 100 may be configured to control the first switch unit 108 such that the first switch unit 108 is in a closed state. In the closed state, the first circuit 118 is electrically closed at the location of the first switch unit 108 by the first transistor 240 of the first switch unit 108. As an effect, the first current I1 may flow through the first switch unit 108 in a forward direction of the first transistor 240 of the first switch unit 108. In an example, the control device 100 may be configured to control the first switch unit 108 such that the first switch unit 108 is in an open state. In particular, the open state refers to the first transistor 240 of the first switch unit 108. In the open state, the first circuit 118 is interrupted and/or disabled at the location of the first switch unit 108 for an electric current in the forward direction of the first transistor 240 of the first switch unit 108. The first switch unit 108 may comprise a first freewheeling diode 234. The first free-wheeling diode 234 may be integrally configured by the first transistor 240 of the first switch unit 108. In another example, the first freewheeling diode 234 may be arranged and/or configured in parallel with the first transistor 240 of the first switch unit 108. The first freewheeling diode 234 may, if the first switch unit 108 and/or the first transistor 240 is in the open state, ensure and/or allow a current to flow through the first switch unit 108 and/or through the first circuit 118 in a direction opposite to the forward direction of the first transistor 240 of the first switch unit 108.

The second control terminal 124 of the control device 100 may be configured to be coupled to the second switch unit 110. In an example, the second control terminal 124 is directly or indirectly coupled to a control terminal of the second switch unit 110. The second switch unit 110 may comprise a second transistor 242, in particular a field effect transistor, such as a MOS transistor. A gate terminal of the second transistor 242 may be configured to control the second transistor 242 and/or the second switch unit 110. In an example, the second switch unit 110 is formed by the second transistor 242. The second control terminal 124 of the control device 100 may be directly or indirectly coupled to the gate terminal of the second transistor 242 of the second switch unit 110, such that the control device 100 may control the second switch unit 110 and/or the second transistor 242 via the second control terminal 124. In an example, the control device 100 may be configured to control the second switch unit 110 such that the second switch unit 110 is in a closed state. In the closed state, the second circuit 120 is electrically closed at the location of the second switch unit 110 by the second transistor 242 of the second switch unit 110. As an effect, the second current I2 may flow through the second switch unit 110 in a forward direction of the second transistor 242 of the second switch unit 110. In an example, the control device 100 may be configured to control the second switch unit 110 such that the second switch unit 110 is in an open state. In particular, the open state refers to the second transistor 242 of the second switch unit 110. In the open state, the second circuit 120 is interrupted and/or disabled at the location of the second switch unit 110 for an electric current in the forward direction of the second transistor 242 of the second switch unit 110. The second switch unit 110 may comprise a second free-wheeling diode 236. In an example, the second free-wheeling diode 236 may be arranged and/or configured in parallel with the second transistor 242 of the second switch unit 110. The second freewheeling diode 236 may, if the second switch unit 110 and/or the second transistor 242 is in the open state, ensure and/or allow a current to flow through the second switch unit 110 and/or through the second circuit 120 in a direction opposite to the forward direction of the second transistor 242 of the second switch unit 110.

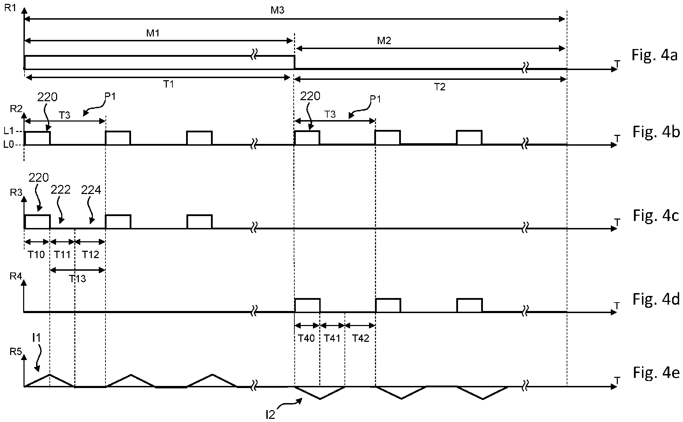

The control device 100 is configured to generate or receive a periodic reference signal R1. The reference signal R1 represents successive reference periods M3. Figure 4A schematically illustrates an example of a single reference period M3 of the reference signal R1. The reference signal R1 may represent a plurality of reference periods M3, wherein the reference periods M3 follow one another in immediate succession.

Each reference period M3 is divided into a first half, referred to as the first reference half period M1, and a second half, referred to as the second reference half period M2. The two reference period halves may be of equal length. The time T1 of the first reference half period M1 may correspond to the time T2 of the second reference half period M2.

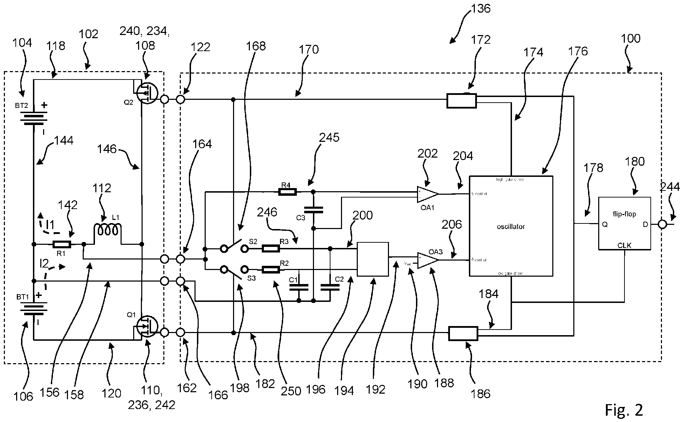

In Figure 2, an example of the control device 100 is shown schematically. For the example of the control device 100 of Figure 2, reference is made to the preceding explanations, preferred features, technical effects and advantages in an analogous manner, as previously explained in connection with the control device 100.

In an example, the control device 100 may receive a signal at an input 244, which may also be referred to as a sensor signal. Based on the sensor signal and/or via the unit 180, which is configured in particular as a flip-flop, the control device 100 may generate the reference signal R1 at the output Q of the unit 180. In another example (not shown), the control device 100 may be configured to receive or generate the reference signal R1 by another unit.

Each first reference period M1 may serve to transport electrical energy from the first battery pack 104 to the second battery pack 106 via the energy buffer 112. Each second reference half period M2 may serve to transport electrical energy from the second battery pack 106 via the energy buffer 112 to the first battery pack 104. Due to the periodicity of the reference signal R1, it may be provided that the first reference half period M1 and the second reference half period M2 follow each other alternately. Each first reference half period M1 is followed by a second reference half period M2. Each second reference half period M2 is again followed by a first reference half period M1. The periodic reference signal R1 may therefore be used to exchange electrical energy in an alternating direction between the first battery pack 104 and the second battery pack 106. The alternating exchange of electrical energy results in very little energy loss. Due to the exchange of electrical energy, an electrical current is generated in the battery packs 104, 106, which may be used for impedance spectroscopy of the battery packs 104, 106.

The control device 100 is configured to generate a control signal R2. Figure 4b schematically illustrates an example of the control signal R2. The control signal R2 may be a periodic control signal R2. The control signal R2 may comprise a plurality of repeating periods P1. Each period P1 may comprise a control pulse 220 in which the reference signal R2 comprises a first value L1. During the remainder of each period P1, the reference signal R2 may comprise a second value L0. The value L1 may be greater than the value L0, or vice versa.

In an example shown in Figure 2, the control device 100 comprises a unit 176 configured to generate the control signal R2. The unit 176 may be configured as an oscillator or comprise an oscillator. The unit 176 may therefore be referred to as oscillator unit 176.

The control device 100 may be configured to route the control signal R2 to the first control terminal 122 in each first reference half period M1. In an example, the control device 100 comprises a unit 172. The reference signal R1 may be transmitted from the unit 180 to the unit 172 via the signal connection 178. The control signal R2 may be transmitted from the oscillator unit 176 to the unit 172 via the connection line 174. The unit 172 may be configured to pass the control signal R2 only during the first reference half period and/or to further transmit the control signal R2 to the first control terminal 122 via the connection line 170. The unit 172 may also be configured not to pass the control signal R2 during the second reference half period M2 and/or not to further transmit it to the first control terminal 122 via the connection line 170. Figure 4c schematically illustrates an example of the portion of the control signal R2 that is routed to the first control terminal 122. The portion of the control signal R2 at the first control terminal 122 may be referred to as the first switching signal R3.

The control signal R2 and/or the first switching signal R3 may be configured to control the first switch unit 108 and/or the first transistor 240 to the closed state during each control pulse 220 during each first reference half period M1. The control signal R2 and/or the first switching signal R3 may further be configured to control the first switch unit 108 and/or the first transistor 240 to the open state during the remaining time. As can be seen from Figure 4c, the first switching signal R3 comprises the periodically repeating control pulses 220 only during each first reference half period M1. Only during each control pulse 220 in the respective first reference half period M1 is the first switch unit 108 and/or the first transistor 240 controlled to the closed state. The remaining time during the first reference half period M1 and during the entire second reference half period M2, the first switch unit 108 and/or the first transistor 240 is controlled in the open state.

Figure 4e schematically illustrates an example of the current through the energy buffer 112. The current through the energy buffer 112 may correspond to the current through the string 114. The current through the energy buffer 112 and/or through the string 114 may be referred to as the string current R5. As an effect, Figure 4e schematically illustrates an example of the string current R5.

During the first period P1 of the first switching signal R3 within the first reference half period M1, the associated control pulse 220 causes the first switch unit 108 and/or the first transistor 240 to be in the closed state during the time T10. As an effect, the current I1 is caused in the first circuit 118 to form the string current R5 during the time T10. At the end of the control pulse 220 during the first period P1 within the first reference half period M1), the closed state of the first switch unit 108 and/or the first transistor 240 ends, so that the first switch unit 108 and/or the first transistor 240 is in the open state during the subsequent time T11 and/or T12 of the first period P1 (during the first reference half period M1). In particular, the energy buffer 112 is an inductive energy buffer 112. As an effect, the energy buffer 112 causes the current I1 to continue to flow. During the time T11, both the first switch unit 108 (and/or the first transistor 240) and the second switch unit 110 (and/or the second transistor 242) are in the open state. During the time T11, the current I1 cannot continue to flow through the first switch unit 108 because the freewheeling diode 234 of the first switch unit 108 is not in the forward direction for the current I1. However, the current II may continue to flow through the second circuit 120 during the time T11 because the second freewheeling diode 236 is in the forward direction for the current I1.

As can be seen from Figure 4e, the current I1 increases during the time T10 of the control pulse 220 (during the period P1 within the first reference half period M1). Thereafter, the current I1 decreases again during the time T 11, in particular to the level at which the current I1 started at the beginning of the corresponding control pulse 220. As an effect, the current I1 during time T10 causes electrical energy to be transferred from the first battery pack 104 to the energy buffer 112. As a further effect, the current I1 causes electrical energy to be transferred from the energy buffer 112 to the second battery pack 106 during the time T11.

The previously exchange process is repeated with each period P1 of the control signal R2 and/or the first switching signal R3 during the first reference half period M1. As an effect, with each period P1 of the control signal R2 and/or the first switching signal R3 during the first reference half period M1, electrical energy is transferred from the first battery pack 104 via the energy buffer 112 to the second battery pack 106. The current I1 during the times T10, T11 may be used for impedance spectroscopy of the first and/or second battery pack 104, 106.

The control device 100 may be configured to route the control signal R2 to the second control terminal 124 in each second reference half period M2. In an example, the control device 100 comprises a unit 186. The reference signal R1 may be transmitted from unit 180 to unit 186 via the signal connection 178. The control signal R2 may be transmitted from the oscillator unit 176 to the unit 186 via the connection line 184. The unit 186 may be configured to pass the control signal R2 only during the second reference half period M2 and/or to further transmit the control signal R2 to the second control terminal 124 via the connection line 182 during the second reference half period M2. The unit 186 may further be configured not to pass the control signal R2 during the first reference half period M1 and/or not to further transmit the control signal R2 to the second control terminal 124 via the connection line 182. Figure 4d schematically illustrates an example of the portion of the control signal R2 that is routed to the second control terminal 124. The portion of the control signal R2 at the second control terminal 124 may be referred to as the second switching signal R4.

The control signal R2 and/or the second switching signal R4 may be configured to control the second switch unit 110 and/or the second transistor 242 to the closed state during each control pulse 220 during each second reference half period M2. The control signal R2 and/or the second switching signal R4 may further be configured to control the second switch unit 110 and/or the second transistor 242 in the open state during the remaining time. As can be seen from Figure 4d, the second switching signal R4 comprises the periodically repeating control pulses 220 only during each second reference half period M2. Only during each control pulse 220 in the respective second reference half period M2 is the second switch unit 110 and/or the second transistor 242 controlled to the closed state. The rest of the time during the second reference half period M2 and during the entire first reference half period M1, the second switch unit 110 and/or the second transistor 242 is controlled in the open state.

During the first period P1 of the second switching signal R4 within the second reference half period M2, the associated control pulse 220 causes the second switch unit 110 and/or the second transistor 242 to be in the closed state during the time T40. As an effect, the current I2 is caused in the second circuit 120 to form the string current R5 during the time T40. At the end of the control pulse 220 (during the first period P1 within the second reference half period M2), the closed state of the second switch unit 110 and/or the second transistor 242 ends, so that the second switch unit 110 and/or the second transistor 242 is in the open state during the subsequent time T41 and/or T42 of the first period P1 (within the second reference half period M2). As previously explained, the energy buffer 112 is in particular an inductive energy buffer 112. As an effect, the energy buffer 112 causes the current I2 to continue to flow. During the time T41, both the second switch unit 110 (and/or the second transistor 242) and the first switch unit 108 (and/or the first transistor 240) are in the open state. During the time T41, the current I2 cannot continue to flow through the second switch unit 110 because the freewheeling diode 236 of the second switch unit 110 is not in the forward direction for the current I2. However, the current I2 may continue to flow through the first circuit 118 during the time T41 because the first freewheeling diode 234 is forward biased for the current I2.

As can be seen in Figure 4e, the current I2 increases during the time T40 of the control pulse 220 (the first period P1 within the second reference half period M2). Thereafter, the current I2 decreases again during the time T41, in particular to the level at which the current I2 started at the beginning of the corresponding control pulse 220. As an effect, the current I2 during time T40 causes electrical energy to be transferred from the second battery pack 106 to the energy buffer 112. As another effect, the current I2 causes electrical energy to be transferred from the energy buffer 112 to the first battery pack 104 during the time T41.

The previously described exchange process is repeated with each period P1 of the control signal R2 and/or the during the second reference half period M2. As an effect, with each period P1 of the control signal R2 and/or the second switching signal R4 during the second reference half period M2, electrical energy is transferred from the second battery pack 104 to the first battery pack 106 via the energy buffer 112. The current I2 during the times T40, T41 may be used for impedance spectroscopy of the first and/or second battery pack 104, 106.

It was previously explained that the sensor terminals 164, 166 may be coupled to the battery, in particular directly or indirectly to the energy buffer 112, such as to measure a sensor signal at the sensor terminals 164, 166. The sensor signal represents a current flow R5 through the energy buffer 112. During each period P1 within the first reference half period M1, the sensor signal may represent the current I1. During each period P1 within the second reference half period M2, the sensor signal may represent the current I2. The string current R5 (or current I1) detected via the sensor signal during the first reference half period M1 may represent the electrical energy transferred from the first battery pack 104 to the second battery pack 106 via the energy buffer 112. The string current R5 (or current I2) detected via the sensor signal during the second reference half period M2 may represent the electrical energy transfered from the second battery pack 106 to the first battery pack 104 via the energy buffer 112. Based on the sensor signal, the control device 100 may determine whether a sufficient amount of electrical energy has been alternately exchanged between the two battery packs 104, 106. Alternatively or additionally, the control device 100 may determine, based on the sensor signal, whether a first amount of electrical energy transferred from the first battery pack 104 to the second battery pack 106 via the energy buffer 112 corresponds to a second amount of electrical energy transferred from the second battery pack 106 to the first battery pack 104 via the energy buffer 112. If there is a difference between the first amount of electrical energy and as the second amount of electrical energy, the control device 100 may adjust the control signal R2 such that the two amounts of electrical energy exchanged, for example in a next reference period M1, correspond to each other. Alternatively or additionally, the control device 100 may adapt the control signal R2 if too small or too large an amount of electrical energy has been exchanged between the two battery packs 104, 106 via the energy buffer 112. Against this background, the control device 100 may be configured to adjust the control signal R2 based on the detected control signal accordingly.

The control device 100 offers the advantage that a sufficient amount and, in particular, an equal amount of electrical energy is exchanged from the first battery pack 104 via the energy buffer 112 to the second battery pack and vice versa. The exchange of electrical energy causes an electrical current I1, I2 in the two battery packs 104, 106, which may be advantageously used for impedance spectroscopy. As an effect, electrical currents may be generated for impedance spectroscopy without electrical energy being lost, and if it is, only in a very small amount.

Figure 4b shows a schematic example of the control signal R2. In particular, the control signal R2 is a signal whose amplitude alternates between a first signal value L0 and a second signal value L1. The control signal R2 may be a periodic signal. Each period P1 of the control signal R2 may comprise a pulse 220, which may also be referred to as the control pulse 220. Each period P1 of the first control signal R2 may comprise an associated time T3. The frequency of the control signal R2 may be a predefined frequency. The frequency of the control signal R2 may also be referred to as the control frequency. The frequency of the control signal may, for example, be between 200 kHz and 2 MHz, in particular 1 MHz. The frequency of the control signal R2 may represent how often the period P1 is repeated per time unit.

In an example, each period P1 of the control signal R2 comprises exactly one control pulse 220. The time T10 of the control pulse 220 may be predefined (for example as an initial value) and/or may be adapted by the control device 100. During the time T10 of the control pulse 220, the control signal R2 may comprise the first signal value L1. During the remaining time T13 of the control signal 220, the control signal R2 may comprise the signal value L0. The control pulse 220 may be a rectangular-shaped control pulse.

It was previously explained that the frequency of the control signal R2 may be between 200 kHz and 2 MHz, for example. Due to this high frequency, the time T10 of the control pulse 220 is comparatively short. The short time T10 of the control pulse 220 offers the advantage that an energy buffer 112 with a small capacity for storing electrical energy and/or with a small space requirement may be used to ensure a transfer of electrical energy with each period P1 between the two battery packs 104, 106 via the energy buffer 114. The capacity and/or the space requirement for the energy buffer may depend on the specification of the battery packs 104, 106.

During each first reference half period M1 of the reference signal R1, the control signal R2 may be routed to the first control terminal 122 as the first switching signal R3. During each second reference half period M2 of the reference signal R1, the control signal R2 may be routed to the second control terminal 124 as the second switching signal R4. The time T1 of the first reference half period M1 is preferably at least a multiple greater than the time T3 of a period P1 of the control signal R2. In an example, the time T1 is at least ten times, at least one hundred times, at least five hundred times or at least one thousand times the time T3. The time T2 of the second reference half period M2 may correspond to the time T1 of the first reference half period M1. The frequency of the reference signal R1 may be referred to as the reference frequency. In an example, the frequency of the reference signal R1 may be between 10 mHz and 10 kHz, in particular 100 mHz, or between 500 Hz and 10 kHz, in particular 1 kHz.

In an example, the control signal R2 is a pulse width modulated, PWM, signal. In an example, the control device 100 and/or the oscillator unit 176 may be configured to adjust the time T10 of the control pulse 220. In an example, the control device 100 and/or the oscillator unit 176 may (re)adjust the time T10 of the control pulse 220 for each period P1. It was previously explained that the sensor signal may represent a current through the energy buffer 112. Based on the sensor signal measured during a period P1, the control device 100 may be configured to adjust the time T10 of the control pulse P1 for the next period P1. In particular, the time T3 of each period P1 remains unchanged. If the time T10 is extended, the time T13 may therefore be shortened.

Figures 4c and 4d schematically illustrate several times T10, T11, T12, T13, and T40, T41, T42, T43 etc., wherein the times from Figures 4c and 4d may apply analogously to the control signal R2 from Figure 4b.

As previously mentioned, the control signal R2 is in particular a periodic control signal. The control signal R2 may therefore comprise a plurality of successive periods P1, each of which has the time T3. Each period P1 or the associated time T3 may be divided into three sub-times, namely a drive time T10, T40, a release time T11, T41, and a wait time T12, T42. Within a period P1, the release time T11, T41 may follow the drive time T10, T40. Within a period P1, the wait time T12, T42 may follow the release time T11, T41. Each period P1 (or the associated time T3) may be formed from a sequence of the drive time T10, T40, the subsequent release time T11, T41, and the subsequent wait time T12, T42. For each period P1, the associated release time T11, T41 and the waiting time T12, T42 may form the time T13.

During the first reference half period M1, the control signal R2 may be routed as the first switching signal R3 to the first control terminal 122 in order to control the first switch unit 108 (or the first transistor 240) repeatedly, in particular periodically, into the closed state, so that with each period P1 (during the first reference half period) electrical energy may be transferred from the first battery pack 104 via the energy buffer 112 to the second battery pack 106.

In an example, the control device 100 is configured to generate the control signal R2 such that the control signal R2 controls the first and/or second switch unit 108, 110 (and/or the respective associated transistor 240, 242) into the closed state during each drive time T10, T40.

In an example, the control device 100 is configured to generate the control signal R2 such that during each release time T11, T41 and/or each wait time T12, T42, the control signal R2 is configured to control the first and/or second switch unit 108, 110 (and/or the respective associated transistor 240, 242, to the open state.

In each first reference half period M1, the control signal R2 may be routed to the first switching unit 108 and/or the first transistor 240 (or the associated gate terminal) as the first switching signal R3, such that the first switching signal R3 controls the first switching unit 108 and/or the first transistor 240 to the closed state during each drive time T10 and/or to the open state during each release time T11 and/or each wait time T12. The drive time T10 may also be referred to as the first drive time T10. During each drive time T10, the control pulse 220 may exist, in particular with the signal value L1.

During the second reference half period M2, the control signal R2 may be routed as the second switching signal R4 to the second control terminal 124 in order to control the second switching unit 110 (or the second transistor 242) repeatedly, in particular periodically, into the closed state, so that with each period P1 (during the second reference half period) electrical energy may be transmitted from the second battery pack 106 via the energy buffer 112 to the first battery pack 104.

In each second reference half period M2, the control signal R2 may be routed as the second switching signal R4 to the second switching unit 110 and/or the second transistor 242 (or the associated gate terminal) so that the second switching signal R4 controls the second switching unit 110 and/or the second transistor 242 into the closed state during each drive time T40 and/or into the open state during each release time T41 and/or each wait time T42. The drive time T40 may also be referred to as the second drive time T40. During each drive time T40, the control pulse 220 may exist, in particular with the signal value L1.

Figure 4e schematically illustrates an example of the string current R5 through the string 114.

In the first reference half period M1, the first switching unit 108 and/or the first transistor 240 may be controlled into the closed state with each period P1 of the first switching signal R3 based on the control pulse 220 during the driving time T10, so that the current I1 is generated. During the drive time T10 of a period P1 (within the first reference half period M1), the value of the current I1 increases, wherein the value of the current I1 decreases again in the same period P1 during the release time T11 following the drive time T10. At the end of the release time T11, the value of the current I1 preferably corresponds to the value of the current I1 at the beginning of the drive time T10. As an effect, the string current R5 has a triangular shape during the drive time T10 and the subsequent release time T11 of a period P1. The area of the triangle may be proportional to the electrical energy transferred from the first battery pack 104 to the second battery pack 106 via the energy buffer 112 during the period P1. The control device 100 may be configured to adjust the drive time T10 and/or the wait time T12 based on the transferred energy during period P1. The greater the driving time T10 and/or the smaller the waiting time T12, the more electrical energy may be transferred from the first energy block 104 via the energy buffer 112 to the second energy block 106 during the first reference half period M1.

Due to a transfer of electrical energy from the first battery pack 104 via the energy buffer 112 to the second battery pack 106, the situation may arise that more electrical energy is stored by the second battery pack 106 than by the first battery pack 104. The first battery pack 104 and the second battery pack 106 may be configured identically. It may be advantageous if the same amount of electrical energy is stored by each of the first battery pack 104 and the second battery pack 106. If a first amount of electrical energy has been transferred from the first battery pack 104 to the second battery pack 106 during the first reference half period M1, it may be desirable that a second amount of electrical energy is transferred from the second battery pack 106 (back) to the first battery pack 104 during the subsequent, second reference half period M2, wherein the second amount of electrical energy should correspond to the first amount of electrical energy. As an effect, at least approximately equal amounts of electrical energy may be exchanged between the two battery packs 104, 106 with no or at least approximately no loss of energy. At the same time, a desired generation of electrical currents may be created running through the battery packs 104, 106 that may be used for impedance spectroscopy of the first battery pack 104 and/or the second battery pack 106.

In the second reference half period M2, with each period P1 of the second switching signal R4, the second switching unit 110 and/or the second transistor 242 may be controlled into the closed state based on the control pulse 220 during the driving time T40, so that the current I2 is generated. During the drive time T40 of a period P1 (within the second reference half period M2), the value of the current I2 increases, wherein the value of the current I2 decreases again in the same period P1 during the release time T41 following the drive time T40. At the end of the release time T41, the value of the current I2 preferably corresponds to the value of the current I2 at the beginning of the drive time T40. As an effect, the string current R5 during the drive time T40 and the subsequent release time T41 of a period P1 (of the second reference half period M2) has a triangular shape (but in this case with the opposite sign with respect to the triangular shape during a period P1 in the first reference half period M1). The area of the triangle may be proportional to the transmitted electrical energy transferred from the second battery block 106 to the first battery block 104 via the energy buffer 112 during the period P1 (of the second reference half period M2). The control device 100 may be configured to adjust the drive time T40 and/or the wait time T42 based on the energy transferred during period P1. The greater the driving time T40 and/or the smaller the waiting time T42, the more electrical energy may be transferred from the second energy block 106 via the energy buffer 112 to the first energy block 104 during the second reference half period M2.

With reference to the preceding explanations, in an example, each driver time T10, T40 may be greater than zero. The driving time T10, T40 and the release time T11, T41 of the same period P1 may be of equal length. However, it is also possible that the release time T11, T41 of a period P1 is greater than the drive time T10, T40 of the same period P1. If the release time T11, T41 of a period P1 is at least as large or larger than the drive time T10, T40 of the same period P1, the current I1, I2 may fall back to the value that the respective current I1, I2 had at the start of the drive time T10, T40. As a further effect, electrical energy may be exchanged between the two battery packs 104, 106 with each period P1. Each waiting time T12, T42 may be greater than zero or may be zero.

In an example, the control device 100 may be configured to generate the control signal R2 such that the control signal R2 during each drive time T10, T40 is configured as a positive control pulse having a value being greater than zero, in particular comprising the value L1. The control device 100 may be configured to generate the control signal R2 such that the control signal R2 is configured as a zero pulse during each release time T11, T41 and/or during each wait time T12, T42, the value of which may comprise in particular a zero value and/or the value L0. In an example, the zero pulse is not suitable for driving the first and/or second switch unit 108, 110 (and/or the respective associated transistor 240, 242) into the closed state.

In an example, the reference signal R1 may comprise multiple reference periods M3. As an effect, electrical energy can be exchanged multiple times between the first battery pack 104 and the second battery pack 106. After the mutual exchange of electrical energy between the battery packs 104, 106, it is desirable that the amount of electrical energy transferred from the first battery pack 104 to the second battery pack 106 is equal to the amount of electrical energy transferred from the second battery pack 106 to the first battery pack 104. The string current R5 may be proportional to the electrical power with which electrical energy is transported from the first battery pack 104 to the second battery pack 106, or vice versa. The electrical energy may be inferred by integrating the string current R5. In a first reference half period M1, the string current R5 may be positive, so that by integrating the string current a value may be determined that is proportional to the electrical energy transferred from the first battery pack 104 to the second battery pack 106. In a subsequent, second reference half period M2, the string current R5 may be negative, so that the previously determined value will be reduced by further integration of the string current R5, since electrical energy is transferred back from the second battery pack 106 to the first battery pack 104. At the end of the second reference half period in two, the aforementioned value is zero in an example, which means that the same amount of electrical energy was transferred in the opposite direction in each of the two reference period halves M1, M2. As an effect, an electrical charge of the two battery packs 104, 106 can stay balanced.

In an example, the control device 100 may be configured to measure the sensor signal during a predefined measurement time. The measurement time may be an integer multiple of the time of the reference period M3. The control device 100 may be configured to integrate the value of the sensor signal into a first measurement value during the measurement time. The first measurement value should preferably be zero, because in this case the same amount of electrical energy was exchanged between the two battery packs 104, 106 in opposite directions during the measurement time.

In an example, the control device 100 is configured, while the sensor signal is measured in the measurement time, to adjust the drive time T10, T40 according to the first measurement value, so that the first measurement value at the end of the measurement time reaches the value zero or a value that is in a predefined first value range. The value range may be between -0.2 and +0.2, for example. The value range means that a small deviation from the ideal value of zero may be accepted. In both of the aforementioned alternatives, however, it is achieved that at least approximately the same amount of electrical energy is exchanged in both directions between the two battery packs 104, 106.

The example control device 100 of Figure 2 may comprise a low-pass unit 245 comprising the capacitor C3 and the impedance R4, the low-pass unit 245 being coupled to the two sensor terminals 164, 166. The low-pass unit 245 may be used as an integrating unit to integrate the electrical voltage between the sensor terminals 164, 166 representing the sensor signal. The electrical voltage may be proportional to the string current through the string 114. The string current R5 is proportional to the electrical power that occurs during the transfer of electrical energy between the battery packs 104, 106. Via the low-pass unit 245, the control device 100 may integrate the value of the sensor signal during the measurement time to the first measurement value represented by an electrical voltage across the capacitor C3. The electrical voltage on the capacitor C3 may be fed to the oscillator unit 176 via an operational amplifier 202 and a signal connection 204. The first measurement value may change continuously over time due to the integrative function of the low-pass unit 245. The oscillator unit 176 may be configured to adjust the drive time T10, T40 of the control signal R2 routed to the signal connections 174, 184 during the measurement time. The adjustment of the drive time T10, T40 causes a changed amount of electrical energy to be transmitted in the respective period P1. The driving time T10, T40 may be adapted by the oscillator unit 176 from period P1 to period P1 so that at the end of the measuring time a first measurement value is transmitted via the capacitor C3, the operational amplifier 202 and the signal connection 204 to the oscillator unit 176, which reaches a value of zero or a value in the predefined first value range.

In an example, the drive time T10, T40 may be adjusted at the end of each reference period M3 by the control device 100 and/or the oscillator unit 176 according to the respective current first measurement value, in particular with the aim that the first measurement value reaches zero or a value that is within the predefined first value range at the end of the next reference period M3. The control device 100 may therefore be configured to integrate the sensor signal into the first measurement value during the measurement time. Furthermore, the control device 100 may be configured to use the respective first measurement value at the end of each reference half period M1, M2 to adjust the drive time T10, T40 for the subsequent reference period M3 (in particular for each period P1 of the control signal R2 in said subsequent reference period M1 such that the measurement value at the end of said subsequent reference period M3 and/or at the end of the measurement time reaches the value zero or a value that is in the predefined first value range. As an effect, it may be achieved that the same amount of energy has been exchanged between the battery packs 104, 106 in both directions.

The amount of electrical energy that may be transferred from the first battery pack 104 to the second battery pack 106 via the energy buffer 112 during a first reference half period M1 should be neither too small nor too large. If the amount of exchanged electrical energy is very small, this may indicate a very small string current R5. The string current may therefore be significantly influenced by even small disturbances. However, such a significant influence should be avoided in order to ensure that the same amount of electrical energy is exchanged in both directions between the battery packs 104, 106. If the amount of electrical energy exchanged is very large, this may indicate a very large string current R5. Although a large string current is robust against disturbances, the large string current R5 may also cause an avoidably large energy loss, which should be prevented.

In an example, the control device 100 is configured to measure the sensor signal at least during each driver time T10 of each first reference half period M1 during the or a predefined measurement time. The control device 100 may be configured to integrate the value of the aforementioned sensor signal, in particular exclusively during the at least one driver time T10 of the at least one (first) reference half period M1 of the measurement time, to form a second measurement value. In an example, the control device 100 may be configured to integrate the sensor signal into the second measurement value during the time T1 of each first reference half period M1. In Figure 4e, the sensor signal (representing the string current R5) comprises a periodic, triangular shape during the time T1 of the first reference half period M1. In this example, integrating the sensor signal would result in the second measurement value, which is proportional to the areas of the triangles. Furthermore, the second measurement value could represent the amount of electrical energy that was transferred from the first battery block 104 to the second battery block 106 via the energy buffer 112 during the first reference half period M1. A second value range may be predefined for the second measurement value, in which the second measurement value should be located. The second value range may be predefined and selected such that respective energy losses are avoided and at the same time a sufficiently high robustness against disturbances is ensured. The control device 100 may be configured to adjust a frequency of the control signal R2 and/or the time T3 of a period P1 of the control signal R2 according to the second measurement value, in particular at the end of each first reference half period M1 or at the end of each reference period M3, so that the second measurement value is within the second value range at the end of the measurement time. As an effect, the previously mentioned advantages may be achieved.

It has already been pointed out previously that Figure 2 schematically illustrates an example of the control device 100. The control device 100 may comprise a third switch unit 168, which may in particular be formed by a transistor, such as a field effect transistor. The control device 100 may further comprise a second low-pass filter circuit 246. The second low-pass filter circuit 246 may comprise the impedance R3 and the capacitor C2. An input of the second low-pass filter circuit 246 may be coupled to the first sensor terminal 164 via the third switch unit 168. Another input of the second low-pass filter circuit 246 may be coupled to the second sensor terminal 166. An output of the second low-pass filter circuit 246 may be coupled to an evaluation unit 248 of the control device 100. An output of the evaluation unit 248 may be coupled to the oscillator unit 176.

A control terminal of the third switch unit 168 may be directly or indirectly coupled to the first control output 122, such that the third switch unit 168 is controlled into the closed state during each control pulse 220 (in the first reference half period M1) and/or during each associated drive time T10. As an effect, the sensor signal is transmitted to the second low-pass filter circuit 246 via the third switch unit 168 during each drive time T10 of each first reference half period M1 such that an electrical voltage across the capacitor C2 represents an average current through the string 114 and/or the energy buffer 112 during the drive times T10 of the first reference half period M1. The average current should not be too small so that the electrochemical impedance spectroscopy (for the first battery pack 104 and or the second battery pack 106) is robust to electromagnetic interference. The average current should not be too large in order to keep electrical energy losses, in particular due to the impedance 142 and/or the impedance R3, as small as possible, in particular negligibly small. A signal may be transmitted to the oscillator unit 146 via the evaluation unit 248 that represents the electrical voltage across the capacitor C2 and/or the average current represented by this voltage. The oscillator unit 176 may be configured to adjust the frequency of the control signal R2 and/or the time T3 of the period P1 of the control signal R2 according to the average current through the string 114 and/or the energy buffer 112. In this context, reference is again made to the second measurement value, which may be determined via the control device 100. The second measurement value may represent the average current through the energy buffer 112, which may relate to an average value of the first current I1 during the drive times T10 in the first reference half period M1. The control device 100 may, for example, use the oscillator unit 176 to change the frequency of the control signal R2 and/or the time T3 of the period P1 of the control signal R2 such that the second measurement value is in the predefined, second reference value range.

In an example, the control device 100 is configured to measure the sensor signal at least during each driver time T40 of each second reference half period M2 during the or a predefined measurement time. The control device may be configured to integrate the value of the aforementioned sensor signal, in particular exclusively during the at least one driver time T40 of the at least one (second) reference half period M2 of the measurement time, to form a third measurement value. In an example, the control device 100 may be configured to integrate the sensor signal into the second measurement value during the time T2 of each second reference half period M2. In Figure 4e, the sensor signal (representing the string current R5) comprises a periodic triangular shape during the time T2 of the second reference half period M2. In this example, integrating the sensor signal would result in the third measurement value, which is proportional to the areas of the triangles. Furthermore, the third measurement value could represent the amount of electrical energy transferred from the second battery block 106 to the first battery block 104 via the energy buffer 112 during the second reference half period M2. For the third measurement value, a third value range may be predefined in which the third measurement value should be located. The third value range may be pre-defined and selected such that respective energy losses are avoided and at the same time a sufficiently high robustness against disturbances is ensured. The control device 100 may be configured to adjust a frequency of the control signal R2 and/or the time T3 of a period P1 of the control signal R2 according to the third measurement value, in particular at the end of each second reference half period M2 or at the end of each reference period M3, so that the third measurement value is within the third value range at the end of the measurement time. As an effect, the previously mentioned advantages may be achieved.

In an example, the control device 100 may comprise a fourth switch unit 198, which may in particular be formed by a transistor, such as a field effect transistor. The control device 100 may further comprise a third low-pass filter circuit 250. The third low-pass filter circuit 250 may comprise the impedance R2 and the capacitor C1. An input of the third low-pass filter circuit 250 may be coupled to the first sensor terminal 164 via the fourth switch unit 198. Another input of the third low-pass filter circuit 250 may be coupled to the second sensor terminal 166. An output of the third low-pass filter circuit 52 may be coupled to the evaluation unit 248 of the control device 100.

A control terminal of the fourth switch unit 198 may be directly or indirectly coupled to the second control terminal 124, such that the fourth switch unit 198 is controlled to the closed state during each control pulse 220 (in the second reference half period M2) and/or during each associated drive time T40. As an effect, the sensor signal is transmitted to the third low-pass filter circuit 250 via the fourth switch unit 198 during each drive time T40 of each second reference half period M2, such that an electrical voltage across the capacitor C1 represents an average current through the string 114 and/or the energy buffer 112 during the drive times T40 of the second reference half period M2. The average current should not be too small so that the electrochemical impedance spectroscopy (for the second battery pack 106 and/or the first battery pack 104) is robust to electromagnetic interference. The average current should not be too large in order to keep electrical energy losses, in particular due to the impedance 142 and/or the impedance R2, as small as possible, in particular negligibly small.

In an example, a signal connection 200 may extend from a node that is between the impedance R3 and the capacitor C2 of the second low-pass filter circuit 246 to the evaluation unit 248, in particular the associated averaging unit 194 of the evaluation unit 248. In addition, a further signal connection 196 may extend from a node, which is between the impedance R2 and the capacitor C1 of the third low-pass filter circuit 250, to the evaluation unit 248, in particular the associated averaging unit 194. Based on the signal transferred via the signal connection 200, the evaluation unit 248, in particular the associated averaging unit 194, may determine the second measurement value. Based on the signal transferred via the signal connection 196, the evaluation unit 248, in particular the associated averaging unit 194, may determine the third measurement value. The evaluation unit 248, in particular the associated averaging unit 194, may also be configured to form a fourth measurement value from the second and third measurement values, which is in particular the average of the magnitude of the second measurement value and the magnitude of the third measurement value. The fourth measurement value may represent an average current through the string 114 and/or the energy buffer 112 of the at least one reference period M3 and/or the measurement time. The fourth measurement value may therefore represent whether a current through the energy buffer 112 was used during the measurement time that is neither too small nor too large. A fourth value range may be predefined for the fourth measurement value, which represents a lower limit for the fourth measurement value and an upper limit for the fourth measurement value. The lower limit of the fourth value range may be defined and/or selected such that robustness against electromagnetic interference is ensured. The upper limit of the fourth value range may thus be defined and/or selected such that a large energy loss is prevented at the same time.

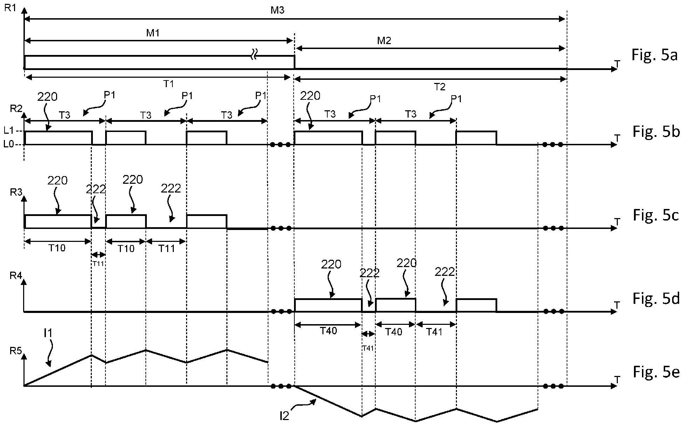

Figures 4b, 4c, 4d show schematically examples where the drive time T10, T40 and the subsequent release time T11, T41 may be the same length. The subsequent waiting time T12, t42 may be greater than zero. In another example, the waiting time T12, T42 may be zero or may be completely omitted. Figures 5b-5e schematically illustrate further signal waveforms of the reference signal R1, the control signal R2, the first switching signal R3, the second switching signal R4 and the sensor signal (representing the string current R5). In the signal waveform of the control signal R2, it may be seen that an initial period P1 may be used in each reference half period M1, M2, in which the release time T11, T41 is shorter than the drive time T10, T40. In the other periods P1 of the respective reference half period M1, M2, the drive time T10, T40 of a period P1 and the subsequent release time T11, T41 of the same period P1 may be identical. As an effect, there may be a sensor signal that represents a current R5, I1, I2 that does not return to zero at the end of each release time T11, T41, but remains at a non-zero value.

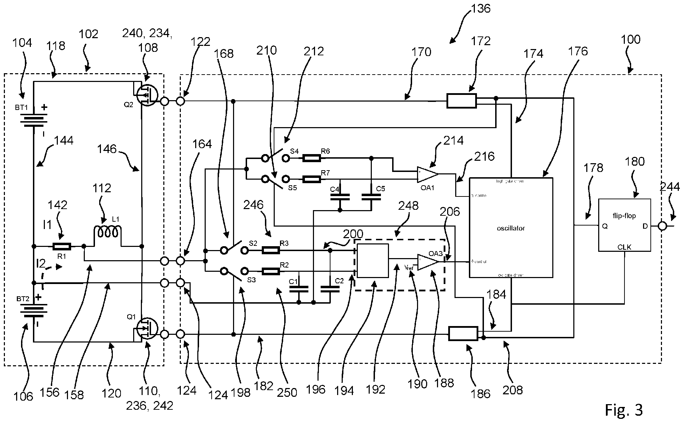

Figure 3 schematically illustrates a further example of the control device 100. For the control device 100 of Figure 3, reference is made to the preceding explanations, preferred features, technical effects and/or advantages in an analogous manner, as they have been explained for the examples of the control device 100 of Figure 2.

The control device 100 in the example of Figure 3 comprises a fourth low-pass filter circuit comprising the impedance R6 and the capacitor C5, and a fifth low-pass filter circuit comprising the impedance R7 and the capacitor C4. The two capacitors C4, C5 may be coupled to the second sensor input 166. The control device 100 may further comprise a fifth switching unit 212 and a sixth switching unit 210. The fifth switching unit may be coupled between the first sensor input 164 and the fourth low-pass filter circuit. The sixth switching unit 210 may be coupled between the first sensor input 164 and the fifth low-pass filter circuit. The fourth and fifth low-pass filter circuits may be coupled to two different inputs of a differential amplifier 214 coupled to the oscillator unit 164 via the signal connection 216.

Figure 1, Figure 2 and Figure 3 also each schematically illustrate an example of a system 136. The system comprises the battery 102 and the control device 100. For the system 136, reference is made to the preceding explanations, preferred features, technical effects and or advantages in an analogous manner as explained for the battery 102 and/or the control device 100. The first control output 122 of the control device 100 may be coupled to the first battery input 160 of the battery 102 via the signal connection 148, wherein the first battery input 160 may be coupled to the first switching unit 108 and/or the first transistor 240. The second control output 124 of the control device 100 may be coupled to the second battery input 162 of the battery 102 via the signal connection 154, wherein the second battery input 162 may be coupled to the second switching unit 110 and/or the second transistor 242. The first battery output 164 may be coupled via the signal connection 156 to a node of the string 114, which is arranged in particular between the energy buffer 112 and the impedance 142. The second battery output 166 may be coupled to a node of the signal connection 144 extending between the first battery pack 104 and the second battery pack 106. Said node may have a direct connection to a node of the signal connection 144 through which the signal connection 144 is connected to the string 114. Therefore, there may be a direct electrical connection between the signal connection 148 and the string end of the string 114. Between the first battery output 164 and the second battery output 166 may be the electrical voltage provided that is the voltage across the impedance 142, which is proportional to the string current R5 through the string 114 and/or the energy buffer 112. The electrical voltage may represent the sensor signal. The first battery output 164 may be coupled to the first sensor terminal 126 of the control device 100 via the signal connection 150. The second battery output 166 may be coupled to the second sensor terminal 128 of the control device 100 via the signal connection 152. Against this background, the control device 100 may measure the sensor signal representing a current through the energy buffer 112.

The system 136 may further comprise another unit (not shown) configured to perform electrochemical impedance spectroscopy. The unit may also be referred to as a spectroscopy unit. The spectroscopy unit may be coupled to at least one of the two battery packs 104, 106 so that the spectroscopy unit may measure a voltage, referred to as battery voltage, of the respective coupled battery pack 104, 106. The spectroscopy unit may further be configured to determine an impedance of the coupled battery pack and/or a state, in particular a health state, of the coupled battery pack based on the battery voltage, which is measured, when the currents I1, I2 is present.

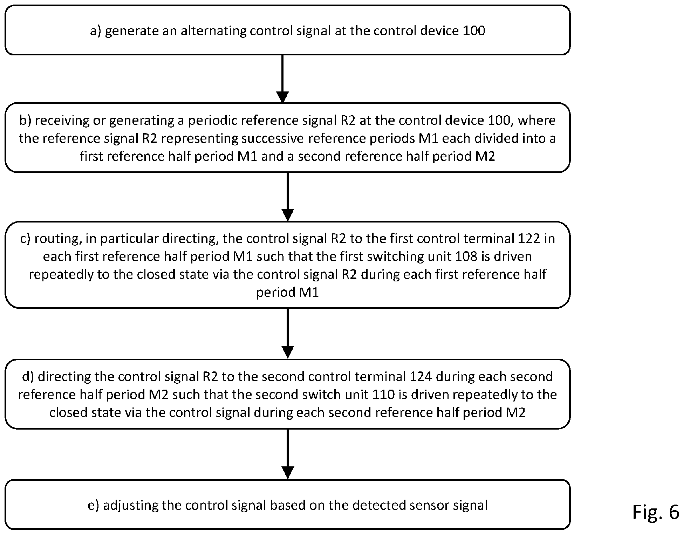

Figure 6 schematically illustrates an example of a method 260 for the control device 100. The control device 100 may be coupled to the battery 102. The method 260 may also be a method for the system 136.

The method 260 may comprise the following steps:
a) generate an alternating control signal at the control device 100,
b) receiving or generating a periodic reference signal R2 at the control device 100, where the reference signal R2 representing successive reference periods M3 each divided into a first reference half period M1 and a second reference half period M2,
c) routing, in particular directing, the control signal R2 to the first control terminal 122 in each first reference half period M1 such that the first switching unit 108 is driven repeatedly to the closed state via the control signal R2 during each first reference half period M1,
d) directing the control signal R2 to the second control terminal 124 during each second reference half period M2 such that the second switch unit 110 is driven repeatedly to the closed state via the control signal during each second reference half period M2, and
e) adjusting the control signal based on the detected sensor signal.

For the method, reference is made to the preceding explanations, preferred features, technical effects and/or advantages in an analogous manner as previously explained for the control device 100, the battery 102 and/or the system 136.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. Control device for a battery,
wherein the battery comprises a first battery pack, a second battery pack, a first switch unit, a second switch unit and an energy buffer,
wherein the energy buffer comprises an inductive and/or capacitive component for buffering electrical energy,
wherein the first battery pack, the first switch unit and the energy buffer are integrated into a first circuit of the battery,
wherein the second battery pack, the second switching unit and the energy buffer are integrated into a second circuit of the battery,
wherein the control device comprises a first control terminal, a second control terminal, a first sensor terminal, and a second sensor terminal, wherein the sensor terminals are configured to be coupled to the energy buffer,
wherein the control device is configured to measure a sensor signal at the sensor terminals representing a current flow through the energy buffer, wherein the first control terminal is configured to be coupled to the first switching unit and the second control terminal is configured to be coupled to the second switching unit,
wherein the control device is configured to generate an alternating control signal,
wherein the control device is configured to receive or generate a periodic reference signal representing successive reference periods each divided into a first reference half period and a second reference half period,
wherein the control device is configured to direct the control signal to the first control terminal in each first reference half period such that the first switching unit is driven repeatedly to the closed state via the control signal during each first reference half period, and
wherein the control device is configured to direct the control signal to the second control terminal during each second reference half period such that the second switch unit is driven repeatedly to the closed state via the control signal during each second reference half period, and
wherein the control unit is configured to adjust the control signal based on the detected sensor signal.

2. The control device according to the preceding claim, wherein a frequency of the control signal is at least twice as large as a frequency of the reference signal.

3. The control device according to any of the preceding claims, wherein the control signal is a pulse width modulated, PWM, signal.

4. The control device according to any of the preceding claims, wherein the control signal is structured in a plurality of successive control periods, wherein each control period is divided into a drive time, a release time and a wait time, wherein the control device is configured to generate the control signal such that the control signal is configured to drive the first and/or second switch unit to the closed state during each drive time, and wherein the control device is configured to generate the control signal such that the control signal is configured to drive the first and/or second switch unit to an open state during each release time and/or during each wait time.

5. The control device according to any of the preceding claims 1 to 3, wherein the control signal is structured in a plurality of successive control periods, wherein each control period is divided into a drive time, a release time and a wait time, and wherein the control device is configured to generate the control signal such that the control signal is configured as a positive control pulse during each drive period, a zero pulse during each release period, and a zero pulse during each wait period.

6. The control device according to any of the preceding claims 4 to 5, wherein for each control period the release time of the respective control period is greater than or equal to the drive time of the same control period.

7. The control device according to any of the preceding claims, wherein the control device is configured to measure the sensor signal during a measurement period and to integrate a value of the sensor signal during the measurement period into a first measurement value, wherein the control device is configured to adjust the drive time during the measurement time according to the first measurement value, so that the first measurement value reaches the value zero at the end of the measurement time or a value in a predefined first value range at the end of the measurement time.

8. The control device according to the preceding claim, wherein the control device is configured, during the measurement period, to adjust the drive time at the end of each control period according to the first measurement value such that the first measurement value reaches zero at the end of the next control period or a value in the predefined first value range at the end of the next control period.

9. The control device according to claim 7, wherein the control device is configured, during the measurement time, to adjust the drive time at the end of each reference half period according to the first measurement value, so that the first measurement value reaches the value zero at the end of the next reference half period or a value in the predefined first value range at the end of the next reference half period.

10. The control device according to any of the preceding claims 7 to 9, wherein the first value range is between minus 0.2 and plus 0.2.

11. The control device according to any of the preceding claims, wherein the control device is configured to measure the sensor signal during each drive time of each first reference half period of the measurement time and to integrate the respective measured values of the sensor signal into a second measurement value, wherein the control device is configured, during the measurement time, to adjust a frequency of the control signal according to the second measurement value such that the second measurement value reaches a value in a predefined second value range.

12. The control device according to any of the preceding claims 1 to 10, wherein the control device is configured to measure the sensor signal during each drive time of the measurement time, wherein the control device is configured to integrate the value of the sensor signal measured exclusively during the drive times of the first reference half periods of the measurement time into a second measurement value, wherein the control device is configured to integrate the value of the sensor signal measured exclusively during the drive times of the second reference half periods of the measurement time into a third measurement value, wherein the control device is configured to form a fourth measurement value from the sum of the magnitude of the second measurement value and the magnitude of the third measurement value, wherein the control device is configured, during the measurement time, to adjust the frequency of the control signal according to the fourth measurement value, so that the fourth measurement value reaches a value within a fourth value range.

13. **A System** comprising:
a battery, and
a control device according to any of the preceding claims,
wherein the battery comprises a first battery pack, a second battery pack, a first switch unit, a second switch unit and an energy buffer,
wherein the energy buffer comprises an inductive and/or capacitive component for buffering electrical energy,
wherein the first battery pack, the first switch unit and the energy buffer are integrated into a first circuit of the battery,
wherein the second battery pack, the second switching unit and the energy buffer are integrated into a second circuit of the battery,
wherein the sensor terminals are coupled to the energy buffer so that a sensor signal between the sensor terminals represents a current flow through the energy buffer, and
wherein the first control terminal is coupled to the first switching unit, and
wherein the second control terminal is coupled to the second switching unit.

14. The system according to the preceding claim, wherein the system comprises a first sensor device and an evaluation unit coupled to the first sensor device, wherein the first sensor device is coupled to the first battery pack and configured to measure a voltage of the first battery pack, referred to as the first battery voltage, and wherein the evaluation unit is configured to determine a first impedance of the first battery pack and/or a first state of the first battery pack based on the first battery voltage.

15. **A Method** for a control device for controlling a battery, wherein the battery comprises a first battery pack, a second battery pack, a first switching unit, a second switching unit and an energy buffer, wherein the energy buffer comprises an inductive and/or capacitive component for buffering electrical energy, wherein the first battery pack, the first switching unit and the energy buffer are integrated into a first circuit of the battery, wherein the second battery pack, the second switching unit and the energy buffer are integrated into a second circuit of the battery, wherein the method comprises the following steps:
a) generate an alternating control signal at the control device,
b) receiving or generating a periodic reference signal at the control device, where the reference signal representing successive reference periods each divided into a first reference half period and a second reference half period,
c) directing the control signal to the first control terminal in each first reference half period such that the first switching unit is driven repeatedly to the closed state via the control signal during each first reference half period, and
d) directing the control signal to the second control terminal during each second reference half period such that the second switch unit is driven repeatedly to the closed state via the control signal during each second reference half period, and
e) adjusting the control signal based on the detected sensor signal.
